Europäisches Patentamt

European Patent Office

Office européen des brevets

(19)

(11) Publication number: **0 130 803**
A2

(12) # EUROPEAN PATENT APPLICATION

(21) Application number: 84304410.8

(22) Date of filing: 28.06.84

(51) Int. Cl.⁴: **C 23 C 14/14**
// C23C14/24, C01B31/00

(30) Priority: 29.06.83 US 509157

(43) Date of publication of application: 09.01.85
Bulletin 85/2

(84) Designated Contracting States: **AT BE CH DE FR GB IT
LI LU NL SE**

(71) Applicant: STAUFFER CHEMICAL COMPANY, Westport
Connecticut 06881 (US)

(72) Inventor: Baumann, John Andrew, 112 Pine Avenue,
Ossining New York 10562 (US)
Inventor: Brock, David Geoffrey, 126 Forest Drive, Mt.
Kisco New York 10549 (US)
Inventor: Kuck, Mark Allen, 445 Warfield Street, Upper
Montclair, N.J. 07043 (US)
Inventor: Miller, Gary Kauilani, 79 Hawley Avenue, Port
Chester New York 10573 (US)

(74) Representative: Smith, Sydney et al, Elkington and Fife
High Holborn House 52/54 High Holborn, London
WC1V 6SH (GB)

(54) Graphite intercalated alkali metal vapour sources.

(57) A vapour deposition process characterised in that an alkali
metal intercalate is used as a source of alkali metal vapour is
disclosed.

The use of an alkali metal intercalate as a source of alkali
metal vapour in a vapour deposition process is also disclosed,
as in a source of alkali metal vapour for use in a vapour deposition process comprising an alkali metal intercalate.

For example, a potassium graphite intercalate, $KC_8$, may
be heated to give a slow controlled release of potassium vapour
for subsequent reaction with phosphorus vapour. Thin films of
$KP_{15}$ and other polyphosphides may be produced by two-
source vapour transport and by vacuum co-evaporation utilis-
ing $KC_8$ as the source of potassium vapour. $RbC_8$ and $CsC_8$
may be utilized as vapour sources to form the corresponding
rubidium and cesium polyphosphides.

The present invention represents an advance over the prior
art.

## Graphite intercalated alkali metal vapour sources

This invention relates to graphite intercalated alkali metal vapour sources; more particularly, it relates to utilizing potassium, rubidium and cesium graphite intercalates as vapour sources to form alkali metal polyphosphides. The sources may be used in various vapour processes and have been utilized in two-source vapour transport and in vacuum co-evaporation.

For further information, reference may be made to, for example, GB-A- 2,113,663 and to the related applications filed herewith, in particular those based on USSN 509,158, USSN 509,175, USSN 581,139 and USSN 581,115.

The above-identified related applications diclose synthesizing alkali metal polyphosphides, particularly $MP_{15}$, wherein M represents an alkali metal, by various vapour processes including two-source vapour transport and chemical vapour deposition. Alkali metals are high reactive and difficulty has been experienced utilizing elemental alkali metals in these processes, due, for example, to the formation of an oxide film thereon which interferes with the processes. The high reactivity of alkali metals also requires specialised procedures and equipment to handle them safely in the laboratory. Graphite intercalated potassium, rubidium and cesium are known to release vapour at rates which depend upon temperature and are commercially available compounds.

It is therefore an object of the present invention to provide alkali metal vapour sources.

Another object of the present invention is to provide controlled release alkali metal vapour sources.

A further object of the present invention is to provide such sources for use in vapour deposition processes, such as vacuum, evaporation, two-source vapour transport, chemical vapour deposition and molecular epitaxy deposition.

Still another object of the present invention is to provide such sources for use in synthesizing alkali metal polyphosphides.

The present invention provides a vapour deposition process characterised in that an alkali metal intercalate is used as a source of alkali metal vapour.

The present invention also provides the use of an alkali metal intercalate as a source of alkali metal vapour in a vapour deposition process.

The present invention further provides a source of alkali metal vapour for use in a vapour deposition process comprising an alkali metal intercalate.

Preferably, the intercalate is a graphite intercalate, more preferably corresponding to the formula: $MC_8$ wherein M represents an alkali metal, preferably potassium, rubidium or cesium.

Alkali metal (K, Rb, Cs) graphite intercalates have now been used as metal sources in the preparation of corresponding metal polyphosphide films in vacuum co-evaporation and in two-source vapour transport. It is believed that these intercalate sources may also be utilized in chemical vapour deposition, such as disclosed in the related applications and in other vapour processes, such as molecular beam epitaxy. In all of these processes, the vapours of separated reactant sources are brought together over heated substrates where the desired product deposits as a film.

A slower, more controllable rate of vaporization is possible with the intercalates as opposed to the metals themselves.

$KC_8$ has now been used in two-source vapour transport as disclosed in the above-identified related applications by first partially inserting the reactant tube into the hot oven first to vaporize potassium from the $KC_8$ and then fully insert the reactant tube to vaporize phosphorus. This partial insertion technique prevents the phosphorus vapour from initially reacting on the $KC_8$ surface and effectively neutralizing its activity.

$KC_8$ has proved particularly effective in vacuum co-evaporation as described in detail in the above-mentioned related applications in particular that based on USSN 581,139 to which reference may be made.

As is well known, the graphite intercalates, such as $KC_8$, as they gradually release potassium vapour pass through several semi-compound stages, such as $KC_{10}$.

The intercalates have been employed in the form of a granular powder.

For further examples of amorphous $KP_{15}$ films formed by vacuum evaporation utilizing granular $KC_8$ in a baffled resistance-heated source, reference may be made to the above-identified related applications, in particular that based on USSN 581,139.

- 4 -

CLAIMS:

1.  A vapour deposition process characterised in that an alkali metal intercalate is used as a source of alkali metal vapour.

2.  A process as claimed in claim 1 wherein the intercalate is a graphite intercalate.

3.  A process as claimed in claim 1 or claim 2 wherein the intercalate corresponds to the formula: $MC_8$ wherein M represents an alkali metal.

4.  A process as claimed in any of claims 1 to 3 wherein M represents potassium, rubidium or cesium.

5.  The use of an alkali metal intercalate as a source of alkali metal vapour in a vapour deposition process.

6.  A source of alkali metal vapour for use in a vapour deposition process comprising an alkali metal intercalate.